# EUROPÄISCHE PATENTANMELDUNG

(11) **EP 3 629 460 A1**
(43) Veröffentlichungstag der Anmeldung: **01.04.2020**
(21) Anmeldenummer: 18197573.1
(22) Anmeldetag: 28.09.2018
(51) Int. Cl.: H02M 1/44, H02M 1/12, H01F 17/04, H03H 7/42, H03H 7/09, H03H 1/00

(54) **STROMKOMPENSIERTE DROSSELVORRICHTUNG**

(71) Anmelder: Siemens Aktiengesellschaft, 80333 München (DE)
(72) Erfinder: Lange, Robert, 08451 Crimmitschau (DE); Seja, Marco, 09661 Rossau / OT Seifersbach (DE)

(57) **Zusammenfassung**

Die Erfindung betrifft eine stromkompensierte Drosselvorrichtung (1) zur Filterung von Gleichtaktstörungen, welche einen ersten Drosselkern (2), aufweisend eine erste Hauptdrosselspule (3) und eine erste Drosseleinheit (4) mit einer ersten Hilfsdrosselspule (5), einen zweiten Drosselkern (6), aufweisend eine zweite Hauptdrosselspule (7) und eine zweite Drosseleinheit (8) mit einer zweiten Hilfsdrosselspule (9), und einen Drosselstromkreis (17) umfasst, wobei die erste Hauptdrosselspule (3) und die erste Hilfsdrosselspule (5) jeweils den ersten Drosselkern (2) umwickeln, wobei die zweite Hauptdrosselspule (7) und die zweite Hilfsdrosselspule (9) jeweils den zweiten Drosselkern (6) umwickeln, wobei die erste Hilfsdrosselspule (5) zwischen einem ersten Anschluss (10) und einem zweiten Anschluss (11) der ersten Drosseleinheit (4) und die zweite Hilfsdrosselspule (11) zwischen einem dritten und einem vierten Anschluss (12,13) der zweiten Drosseleinheit (10) elektrisch verbunden ist und wobei der erste Anschluss (6) mit dem dritten Anschluss (12) und der zweite Anschluss (7) mit dem vierten Anschluss (13) elektrisch verbunden ist und die Verbindungen dieser Anschlüsse den Drosselstromkreis (17) ausbildet.

## Beschreibung

Die Erfindung betrifft eine stromkompensierte Drosselvorrichtung zur Filterung von Gleichtaktstörungen beim Betrieb eines Umrichters.

Auf Grund von gesetzlichen Vorgaben, Normen und anderen elektronischen bzw. elektrischen Vorgaben für den Betrieb von beispielsweise Umrichtern der Antriebstechnik müssen leitungsgebundene Störaussendungen in elektrischen Netzen, welche mit dem Umrichter verbunden sind, minimiert werden.

So können in elektrischen Netzen Gleichtaktstörungen auftreten, wobei mit Gleichtaktstörungen Störspannungen und Störströme auf elektrischen Leitungen welche elektrischen Komponenten, wie z.B. Umrichter, mit anderen elektrischen Geräten und Bauelementen verbinden. Die Gleichtaktstörungen bilden sich mit gleicher Phasenlage und Stromrichtung sowohl auf der Hinleitung wie auch der Rückleitung zwischen diesen elektrischen Geräten und Bauelementen aus.

Gleichtaktstörungen wirken demnach auf die betroffenen elektrischen Leitungen zu gleichen Teilen, die Gleichtakt-Störströme fließen im Gegensatz zu den Lastströmen gleichsinnig. Die Gleichtakt-Störspannungen weisen in den elektrischen Leitungen die gleiche Amplitude und Phasenlage auf. Die Gleichtaktstörungen verschlechtern somit sowohl die elektrischen Netze wie auch die in den elektrischen Netzen betriebenen elektrischen Geräte insbesondere auch bzgl. deren Elektro-Magnetischer Verträglichkeit (EMV).

Um Gleichtaktstörungen zu vermeiden bzw. zu bedämpfen, haben sich stromkompensierte Drosseln in verschiedenen elektrischen Filterstrukturen etabliert.

Bekannte stromkompensierte Drosseln sind derart aufgebaut und verschaltet, dass alle Leitungswicklungen auf einem Magnetkern angeordnet sind. Für zweiphasige Gleichspannungs- oder Wechselspannungsnetze sind das im Allgemeinen 2 Leitungswicklungen für 2 Phasen des Netzsystems bei dreiphasigen Drehstromnetzen im Allgemeinen 3 Leitungswicklungen für drei Phasen des Netzsystems.

Die Verschaltung der Leitungswicklungen erfolgt am gemeinsamen Magnetkern in einer Weise, dass sich das aus der Summe der über die Leitungswicklungen geführten Lastströme ergebende magnetische Feld im gemeinsamen Kern aufhebt. Daher erfolgt eine magnetische Aussteuerung des Magnetkerns der stromkompensierten Drossel nur durch parasitäre Effekte und ist somit sehr gering.

Auf Grund dieser Tatsache lassen sich für Gleichtaktstörungen sehr große Induktivitäten erzielen. Elektrische Störungen, die über die Wicklungen der stromkompensierten Drossel gleichsam wirken, kompensieren sich nicht und werden entsprechend bedämpft.

Die derzeit am Markt befindlichen stromkompensierten Drosseln sind insbesondere für die THT-Fertigung (THT - Through Hole Technology) oder SMD-Fertigung (SMD - Surface Mounted Device) aufgrund deren Baugröße und ihres Gewichtes für den Einsatz kaum noch geeignet.

Ferner kann insbesondere bei dreiphasigen Drehstromnetzen der notwendige Abstand zur Einhaltung der Luft- und Kriechstrecken zwischen den einzelnen Leitungswicklungen auf dem Magnetkern sehr großen Baugrößen hervorrufen. Dies wirkt sich beispielsweise in Umrichtern kleinerer Leistung besonders negativ auf den Platzbedarf der stromkompensierten Drossel und deren räumlicher Anordnung aus. Bei der Verwendung eines beispielsweise Ringkernes als Magnetkern für die dreiphasigen Drehstromnetze ist die Leitungsführung meist auf einer Leiterplatte nur sehr aufwendig zu realisieren, was mit Blick auf die Abstandshaltung zur Einhaltung der Luft- und Kriechstrecken zwischen den einzelnen Leitungswicklungen zu einem Übersprechen zwischen gestörten und entstörten Leitungen führen kann.

Der Erfindung liegt daher die Aufgabe zugrunde, eine stromkompensierte Drosselvorrichtung zur Filterung von Gleichtaktstörungen vorzuschlagen, welche aufgrund einer reduzierten Baugröße flexibler an Einbauanforderungen anpassbar ist. Ferner liegt der Erfindung die Aufgabe zugrunde, einen Umrichter mit der stromkompensierten Drossel bereitzustellen.

Die Aufgabe wird durch eine stromkompensierte Drosselvorrichtung mit den in Anspruch 1 angegebenen Merkmalen gelöst. Ferner wird die Aufgabe durch einen Umrichter mit den in Anspruch 8 angegebenen Merkmalen gelöst.

Für die Lösung der Aufgabe wird eine stromkompensierte Drosselvorrichtung zur Filterung von Gleichtaktstörungen vorgeschlagen, welche einen ersten Drosselkern, aufweisend eine erste Hauptdrosselspule und eine erste Drosseleinheit mit einer ersten Hilfsdrosselspule umfasst, welche einen zweiten Drosselkern, aufweisend eine zweite Hauptdrosselspule und eine zweite Drosseleinheit mit einer zweiten Hilfsdrosselspule umfasst, und welche einen Drosselstromkreis umfasst, wobei die erste Hauptdrosselspule und die erste Hilfsdrosselspule jeweils den ersten Drosselkern umwickeln, wobei die zweite Hauptdrosselspule und die zweite Hilfsdrosselspule jeweils den zweiten Drosselkern umwickeln, wobei die erste Hilfsdrosselspule zwischen einem ersten Anschluss und einem zweiten Anschluss der ersten Drosseleinheit und die zweite Hilfsdrosselspule zwischen einem dritten und einem vierten Anschluss der zweiten Drosseleinheit elektrisch verbunden ist und wobei der erste Anschluss mit dem dritten Anschluss und der zweite Anschluss mit dem vierten Anschluss elektrisch verbunden ist und die Verbindungen dieser Anschlüsse den Drosselstromkreis ausbildet.

Mittel dieser stromkompensierte Drosselvorrichtung kann ein bisher für eine vergleichbare Filterung von Gleichtaktstörungen notwendiger einzelner Drosselkern zerlegt werden in den ersten Drosselkern und den zweiten Drosselkern, was die einzelnen Baugrößen des ersten und des zweiten Drosselkerns jeweils vorteilhaft reduziert.

Während in elektrischen Phasen eines Gleichspannungssystems oder eines Wechselspannungssystems die Hauptdrosselspulen den Laststrom führen, sind die Hilfsdrosselspulen als Teil der Drosseleinheiten über deren Anschlüsse zu dem Drosselstromkreis elektrisch miteinander verbunden. Im Betrieb bildet sich durch die vom Laststrom abhängigen magnetischen Felder wie auch durch die vom Gleichtaktstrom abhängigen Gleichtakt-Magnetfelder der Drosselkerne über die Hilfsdrosseln in dem Drosselstromkreis ein Kompensationsstrom aus, welcher die Gleichtaktstörungen vorteilhaft kompensiert bzw. bedämpft.

Die räumliche Anordnung der Drosselkerne, zusammen mit deren Hauptdrosselspulen und Hilfsdrosselspulen, kann nun flexibel durch die Entzerrung mittels des Drosselstromkreises für den Einbau der stromkompensierten Drosselvorrichtung in vorteilhafter Weise vorgenommen werden. Die Baugrößen der einzelnen elektrischen Bauelemente der stromkompensierten Drosselvorrichtung können reduziert werden.

Vorteilhafte Ausgestaltungsformen des modularen Umrichters sind in den abhängigen Ansprüchen angegeben.

Bei einer ersten vorteilhaften Ausgestaltungsform der stromkompensierte Drosselvorrichtung umfasst die stromkompensierte Drosselvorrichtung einen dritten Drosselkern, eine dritte Hauptdrosselspule und eine dritte Drosseleinheit, welche eine dritte Hilfsdrosselspule aufweist, wobei die dritte Hauptdrosselspule und die dritte Hilfsdrosselspule jeweils den dritten Drosselkern umwickeln, wobei die dritte Hilfsdrosselspule zwischen einem fünften und einem sechsten Anschluss der dritten Drosseleinheit elektrisch verbunden ist und wobei der fünfte Anschluss jeweils mit dem ersten Anschluss und dem dritten Anschluss und der sechste Anschluss jeweils mit dem zweiten Anschluss und dem vierten Anschluss am Drosselstromkreis elektrisch verbunden ist.

Mittels der Ausgestaltungsform kann die stromkompensierte Drosselvorrichtung in ein Drehstromsystem integriert werden. Der Drosselstromkreis wird erweitert, indem die dritte Hilfsdrosselspule der dritten Drosseleinheit über deren fünften und sechsten Anschluss mit dem Drosselstromkreis elektrisch verbunden ist.

Somit kann ein Magnetkern, der bisher drei Drosseln aufwies, ersetzt bzw. entzerrt werden und es kann eine Aufteilung der elektrischen Funktionalität auf drei Drosselkerne und die jeweiligen Hilfsdrosselspulen und Hauptdrosselspulen erfolgen.

Diese Lösung eignet sich besonders vorteilhaft, um die räumliche Anordnung der Drosselkerne zusammen mit deren Hauptdrosselspulen und Hilfsdrosselspulen flexibel an die Erfordernisse eines Einbauortes für den Einsatz der stromkompensierte Drosselvorrichtung in dreiphasigen Drehstromnetzen anzupassen. Die Baugrößen der einzelnen elektrischen Bauelemente der stromkompensierten Drosselvorrichtung können dabei erheblich reduziert werden.

Bei einer weiteren vorteilhaften Ausgestaltungsform der stromkompensierte Drosselvorrichtung umwickelt die erste Hauptdrosselspule separat und überlappungsfrei von der ersten Hilfsdrosselspule den ersten Drosselkern, umwickelt die zweite Hauptdrosselspule separat und überlappungsfrei von der zweiten Hilfsdrosselspule den zweiten Drosselkern und umwickelt die dritte Hauptdrosselspule separat und überlappungsfrei von der dritten Hilfsdrosselspule den, soweit vorhanden, dritten Drosselkern.

Der Vorteil der separaten und überlappungsfreien Umwicklung der Hauptdrosselspule am Drosselkern zur Umwicklung der Hilfsdrosselspule am Drosselkern ist die Vergrößerung von deren Luft- und Kriechstrecken untereinander. Ferner ist es auch vorteilhaft, dass eine derartige Umwicklung von Hauptdrosselspule und Hilfsdrosselspule am Drosselkern eine geringe kapazitive Kopplung der Hauptdrosselspule gegenüber der Hilfsdrosselspule am Drosselkern im Betreib der stromkompensierte Drosselvorrichtung erzeugt. Die niedrige kapazitive Kopplung ist ein Parameter der stromkompensierte Drosselvorrichtung, welcher deren Effizienz bei der Kompensation und Dämpfung der Gleichtaktstörungen aufzeigt.

Bei einer weiteren vorteilhaften Ausgestaltungsform der stromkompensierten Drosselvorrichtung sind der erste und der zweite Drosselkern und, soweit vorhanden, der dritte Drosselkern kreisförmig ausgebildet, insbesondere in Form einer Ringkerndrossel, oder rechteckförmig ausgebildet.

Die Anordnung bzw. Verteilung der Hauptdrosselspulen und der Hilfsdrosselspulen an den jeweiligen Drosselkernen ist bei der kreisförmigen Ausbildung oder der rechteckförmigen Ausbildung der Drosselkerne im Produktionsverfahren gegenüber anderen Drossel-Formen (E-Form, D-Form) einfacher fertigbar.

Bei einer weiteren vorteilhaften Ausgestaltungsform der stromkompensierten Drosselvorrichtung weist die erste Drosseleinheit einen ersten Messsensor auf, welcher gemeinsam mit der ersten Hilfsdrosselspule elektrisch zwischen dem ersten Anschluss und dem zweiten Anschluss der ersten Drosseleinheit verbunden ist und/oder weist die zweite Drosseleinheit einen zweiten Messsensor auf, welcher gemeinsam mit der zweiten Hilfsdrosselspule elektrisch zwischen dem dritten Anschluss und dem vierten Anschluss der zweiten Drosseleinheit verbunden ist und/oder weist die, soweit vorhanden, dritte Drosseleinheit einen dritten Messsensor auf, welcher gemeinsam mit der dritten Hilfsdrosselspule elektrisch zwischen dem fünften Anschluss und dem sechsten Anschluss der dritten Drosseleinheit verbunden ist.

Messsensoren können beispielsweise ein Messgerät oder ein Messshunt zur Messung der Stromstärke sein. Die Messung kann in vorteilhafter Weise galvanisch getrennt von der den Laststrom führenden Hauptdrosselspulen über die Hilfsdrosselspulen im Drosselstromkreis erfolgen. Der Strom kann auch mittels einer potentialgebundenen Spannungsmessung als Messsensor erfasst werden. Hier kann dann auf den Einsatz von kostenintensiven isolierten Analog-/Digital-Wandler verzichtet werden.

Bei einer weiteren vorteilhaften Ausgestaltungsform der stromkompensierten Drosselvorrichtung weist die erste Drosseleinheit eine erste Filterkomponente auf, welche gemeinsam mit der ersten Hilfsdrosselspule elektrisch zwischen dem ersten Anschluss und dem zweiten Anschluss der ersten Drosseleinheit verbunden ist und/oder weist die zweite Drosseleinheit eine zweite Filterkomponente auf, welche gemeinsam mit der zweiten Hilfsdrosselspule elektrisch zwischen dem dritten Anschluss und dem vierten Anschluss der zweiten Drosseleinheit verbunden ist und/oder weist die, soweit vorhanden, dritte Drosseleinheit eine dritte Filterkomponente auf, welche gemeinsam mit der dritten Hilfsdrosselspule elektrisch zwischen dem fünften Anschluss und dem sechsten Anschluss der dritten Drosseleinheit verbunden ist.

Mittels einer oder mehrerer der Filterkomponenten im Drosselstromkreis können die Filtereigenschaften der stromkompensierten Drosselvorrichtung weiter beeinflusst und vorteilhaft verbessert werden. So werden damit die Dämpfung oder die Ausblendung einzelner Frequenzen oder Frequenzbereiche möglich. Eine Filterkomponente kann in einer einfachen Ausführung z.B. ein RC-Glied, also ein passives Filterelement sein aber auch ein aktives Filterelement mit einer dafür vorgesehenen Regelung oder Steuerung.

Bei einer weiteren vorteilhaften Ausgestaltungsform der stromkompensierten Drosselvorrichtung sind der erste und der zweite Drosselkern und, soweit vorhanden, der dritte Drosselkern jeweils Ferritkerne oder jeweils Pulverkerne.

Ferritkerne können z.B. MnZn-Ferritkerne, NiZn-Ferritkerne sein, während Pulverkerne z.B. Eisenpulverkerne, SiFe-Pulverkerne, SiAlFe-Pulverkerne, NiMoFe-Pulverkerne oder Ni-Fe-Pulverkerne sein können.

Die Vorteile von Ferritkernen liegen z.B. in ihren geringen Kernverluste über einen weiten Frequenzbereich und ihren niedrigen Kosten in der Herstellung.

Die Vorteile von Pulverkernen gegenüber z.B. lamellierten Metallkernen sind die geringeren Wirbelstromverluste, welche bei höheren Frequenzen auftreten. Pulverkerne eignen sich daher für den Einsatz von Gleichtaktstörungen höherer Frequenzen, deutlich über denen der Netzfrequenz, und wo hohe magnetische Gleichfelder sich überlagern.

Für die Lösung der Aufgabe wird ebenfalls ein Umrichter zum Betreiben einer elektrischen Maschine vorgeschlagen, welcher eine stromkompensierte Drosselvorrichtung nach einem der vorhergehenden Ansprüche aufweist, einen Gleichrichter aufweist, der elektrisch mit einem ersten Drehstromsystem verbunden ist, einen Wechselrichter aufweist, der elektrisch mit einem zweiten Drehstromsystem verbunden ist und der einen Gleichspannungszwischenkreis aufweist, der den Gleichrichter mit dem Wechselrichter elektrisch verbindet.

Bei einer ersten vorteilhaften Ausgestaltungsform des Umrichters ist die stromkompensierte Drosselvorrichtung elektrisch in dem ersten Drehstromsystem angeordnet.

Bei einer weiteren vorteilhaften Ausgestaltungsform des Umrichters ist die stromkompensierte Drosselvorrichtung elektrisch in dem zweiten Drehstromsystem angeordnet.

Bei einer weiteren vorteilhaften Ausgestaltungsform des Umrichters ist die stromkompensierte Drosselvorrichtung elektrisch in dem Gleichspannungszwischenkreis angeordnet.

Bei einer weiteren vorteilhaften Ausgestaltungsform des Umrichters ist die stromkompensierte Drosselvorrichtung in den Umrichter integriert ist. Unter Integration wird verstanden, dass die stromkompensierte Drosselvorrichtung als eine von mehreren Baugruppen des Umrichters (Steuerung, Leistungsteil etc.) innerhalb des Umrichters, also z.B. durch ein Umrichtergehäuse umschlossen, angeordnet ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Figuren näher erläutert werden. Es zeigt:
- FIG 1: eine schematische Darstellung einer bekannten stromkompensierten Drossel mit einem Umrichter in einem ersten Drehstromsystem,
- FIG 2: eine schematische Darstellung einer bekannten stromkompensierten Drossel in einem Gleichspannungszwischenkreis nach FIG 1,
- FIG 3: eine erste schematische Darstellung einer erfindungsgemäßen stromkompensierten Drosselvorrichtung in einem Gleichspannungszwischenkreis,
- FIG 4: eine weitere schematische Darstellung der erfindungsgemäßen stromkompensierten Drosselvorrichtung in dem Gleichspannungszwischenkreis nach FIG 3,
- FIG 5: eine erste schematische Darstellung einer bekannten stromkompensierten Drossel in einem Drehstromsystem nach FIG 1,
- FIG 6: eine erste schematische Darstellung der erfindungsgemäßen stromkompensierten Drosselvorrichtung in einem Drehstromsystem,
- FIG 7: eine zweite schematische Darstellung der erfindungsgemäßen stromkompensierten Drosselvorrichtung im Drehstromsystem nach FIG 6,
- FIG 8: eine dritte schematische Darstellung der erfindungsgemäßen stromkompensierten Drosselvorrichtung im Drehstromsystem nach FIG 6 und
- FIG 9: eine schematische Darstellung eines Umrichters mit der erfindungsgemäßen stromkompensierten Drosselvorrichtung im Drehstromsystem nach der FIG 6.

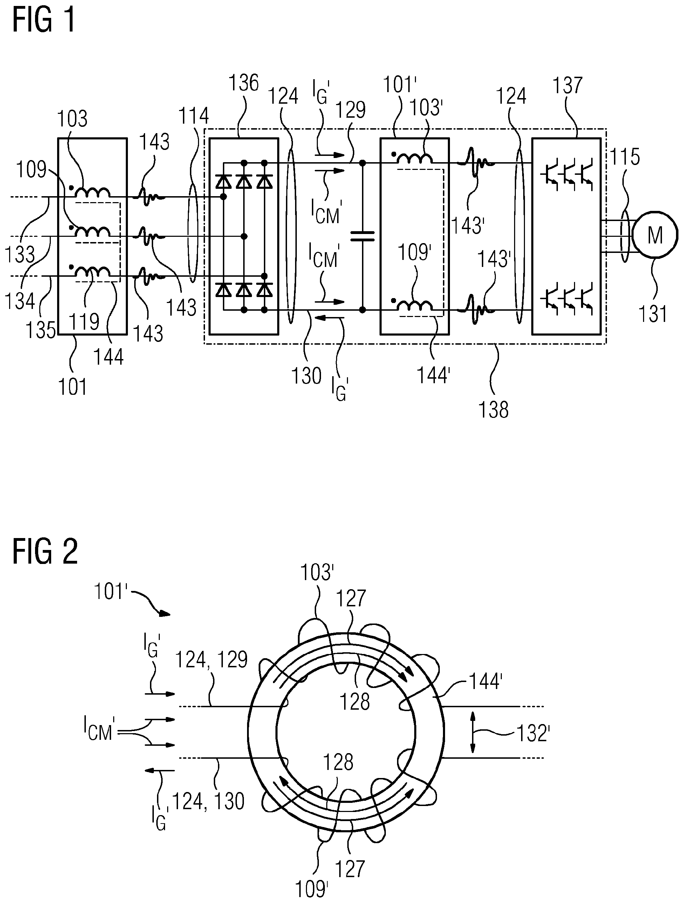

Die FIG 1 zeigt eine schematische Darstellung eines Umrichters 138 mit einer bekannten stromkompensierten Drossel 101 in einem ersten Drehstromsystem 114.

Der Umrichter 138 ist über seinen Gleichrichter 136 mit dem ersten Drehstromsystem 114 elektrisch verbunden und über seinen Wechselrichter 137 mit einem zweiten Drehstromsystem 115 elektrisch verbunden. Eine mit dem zweiten Drehstromsystem 115 elektrisch verbundene elektrische Maschine 131 ist mittels des Umrichters 138 betreibbar.

Der Gleichrichter 114 ist über einen Gleichspannungszwischenkreis 124 mit dem Wechselrichter 137 elektrisch verbunden. In dem Gleichspannungszwischenkreis 124 ist zwischen dessen erster Gleichspannungsphase 129 und zweiter Gleichspannungsphase 130 eine stromkompensierende Drossel 101' elektrisch angeordnet. Die stromkompensierte Drossel 101' umfasst eine erste Drossel 103' in der ersten Gleichspannungsphase 129 und eine zweite Drossel 109' in der zweiten Gleichspannungsphase 130, wobei die Drosselspulen 103',109' einen gemeinsamen Drosselkern 144' aufweisen. In der ersten Gleichspannungsphase 129 fließt ein Gleichtaktstrom I_{CM}' in gleicher Richtung wie ein Lastgleichstrom I_{G}'. In der zweiten Gleichspannungsphase 130 fließt der Lastgleichstrom I_{G}' in entgegengesetzter Richtung zum Gleichtaktstrom I_{CM}'. In den beiden Gleichspannungsphase 129,130 des Gleichspannungszwischenkreises 124 sind Gleichtaktstörungen 143' schematisch dargestellt.

Im ersten Drehstromsystem 114 ist ebenfalls eine stromkompensierte Drossel 101 elektrisch angeordnet, wobei schematisch Gleichtaktstörungen 143 in der ersten Wechselspannungsphase 133, der zweiten Wechselspannungsphase 134 und der dritten Wechselspannungsphase 135 des ersten Drehstromsystems 114 gezeigt werden. Die stromkompensierende Drossel 101 umfasst eine erste Drosselspule 103 in der ersten Wechselspannungsphase 133, eine zweite Drosselspule 109 in der zweiten Wechselspannungsphase 134 und eine dritte Drosselspule 119 in der dritten Wechselspannungsphase 135, wobei alle Drosselspulen 103,109,119 einen gemeinsamen Drosselkern 144 aufweisen.

In FIG 2 wird eine schematische Darstellung einer bekannten stromkompensierten Drossel 101' in einem Gleichspannungszwischenkreis 124 nach FIG 1 aufgezeigt.

Die erste Drosselspule 103' und die zweite Drosselspule 109' umwickeln den gemeinsame Drosselkern 144', wobei die erste Drosselspule 103' mit der ersten Gleichspannungsphase 129 und die zweite Drosselspule 109' mit der zweiten Gleichspannungsphase 130 des Gleichspannungszwischenkreises 124 verbunden ist.

In der ersten Gleichspannungsphase 129 fließt ein Gleichtaktstrom I_{CM}' in gleicher Richtung wie ein Lastgleichstrom I_{G}'. In der zweiten Gleichspannungsphase 130 fließt der Lastgleichstrom I_{G}' in entgegengesetzter Richtung zum Gleichtaktstrom I_{CM}'.

In der gemeinsamen Drosselspule 144' wird das Last-Magnetfeld 127 an der ersten Drosselspule 103', also das magnetische Feld, was sich durch den Lastgleichstrom I_{G}' aufbaut und das Gleichtakt-Magnetfeld 128 an der ersten Drosselspule 103', also das magnetische Feld, was sich durch den Gleichtaktstrom I_{CM}' aufbaut, gezeigt. Beide Magnetfelder 127,128 verlaufen hier in ihrer Richtung gleichsinnig.

Ebenso an der gemeinsamen Drosselspule 144' gezeigt wird das Last-Magnetfeld 127 an der zweiten Drosselspule 109', also das magnetische Feld, was sich durch den Lastgleichstrom I_{G}' aufbaut und das Gleichtakt-Magnetfeld 128 an der zweiten Drosselspule 109', also das magnetische Feld, was sich durch den Gleichtaktstrom I_{CM}' aufbaut. Beide Magnetfelder 127,128 verlaufen hier in ihrer Richtung gegensinnig.

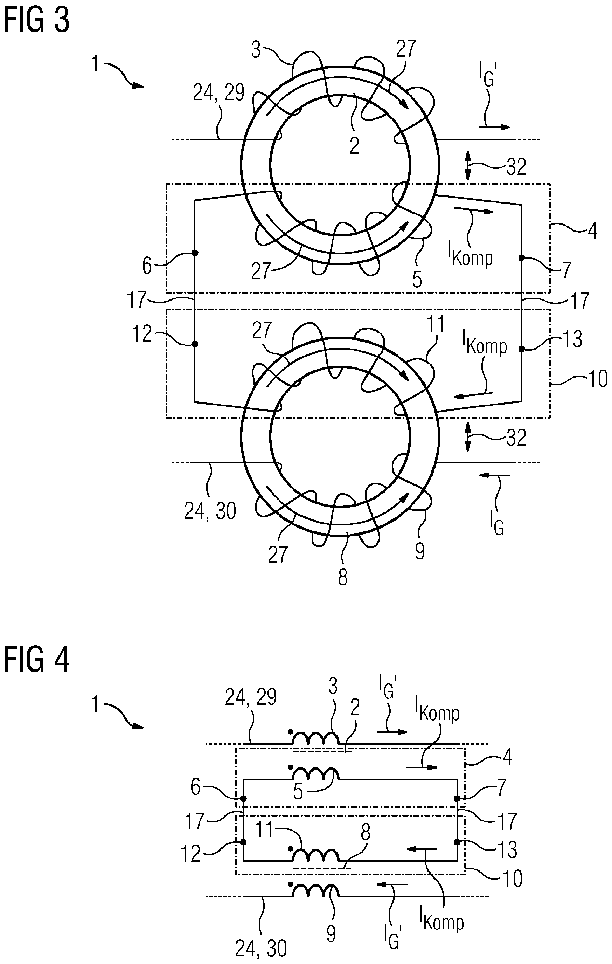

Mit der FIG 3 wird eine erste schematische Darstellung einer erfindungsgemäßen stromkompensierten Drosselvorrichtung 1 in einem Gleichspannungszwischenkreis 24 visualisiert.

Die erste Hauptdrosselspule 3 und die erste Hilfsdrosselspule 5 umwickeln jeweils den ersten Drosselkern 2 und die zweite Hauptdrosselspule 9 und die zweite Hilfsdrosselspule 11 umwickeln jeweils den zweiten Drosselkern 8.

Während die erste Hauptdrosselspule 3 mit der ersten Gleichspannungsphase 29 des Gleichspannungszwischenkreis 24 elektrisch verbunden ist und dort der Lastgleichstrom I_{CM} fließt, ist die zweite Hauptdrosselspule 9 mit der zweiten Gleichspannungsphase 30 des Gleichspannungszwischenkreis 24 elektrisch verbunden, wobei auch hier der Lastgleichstrom I_{CM} fließt.

Die erste Hilfsdrosselspule 5 der ersten Drosseleinheit 4 ist über deren ersten Anschluss 6 mit der zweiten Hilfsdrosselspule 11 der zweiten Drosseleinheit 10 mittels deren dritten Anschluss 12 elektrisch verbunden. Ebenso ist die erste Hilfsdrosselspule 5 der ersten Drosseleinheit 4 über deren zweiten Anschluss 7 mit der zweiten Hilfsdrosselspule 11 der zweiten Drosseleinheit 10 mittels deren vierten Anschluss 13 elektrisch verbunden. Diese elektrischen Verbindungen bilden den Drosselstromkreis 17 aus.

In dem Drosselstromkreis 17 fließt im Betrieb der stromkompensierten Drosselvorrichtung 1 der Kompensationsstrom I_{KOMP}, welcher die Gleichtaktstörungen kompensiert oder zumindest dämpft. In den Drosselkernen 2,8 ist das Last-Magnetfeld 27, also das magnetische Feld, welches durch den Lastgleichstrom I_{G} gebildet wird, zu sehen. Ferner kennzeichnet der Wicklungsabstand 32 den bzgl. der Einhaltung von Luft- und Kriechstrecken wichtigen räumlichen Abstand zwischen der ersten Hauptdrosselspule 3 und der ersten Hilfsdrosselspule 5 sowie der zweiten Hauptdrosselspule 9 und der zweiten Hilfsdrosselspule 11.

In FIG 4 wird eine weitere schematische Darstellung der erfindungsgemäßen stromkompensierten Drosselvorrichtung in dem Gleichspannungszwischenkreis nach FIG 3 aufgezeigt, wobei hier zur besseren Veranschaulichung aus elektrischer Sicht die schematische Darstellung mittels eines elektrischen Schaltplans mit entsprechender Symbolik gewählt wurde und wobei inhaltliche Betrachtungen den Betrachtungen nach FIG 3 entsprechen.

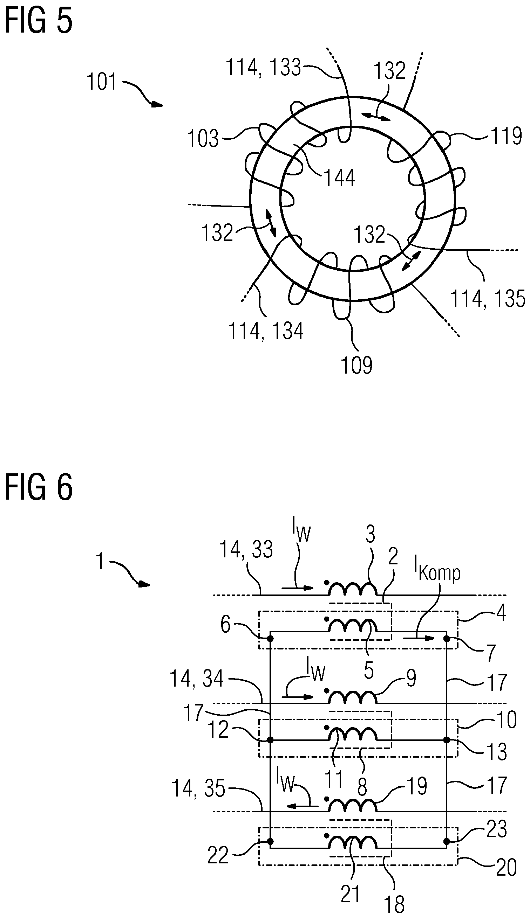

Die FIG 5 offenbart eine bekannte stromkompensierte Drossel 101 in einem ersten Drehstromsystem nach FIG 1. Die stromkompensierte Drossel 101 hat einen gemeinsamer Drosselkern 144, welcher von einer ersten Drosselspule 103, einer zweiten Drosselspule 109 und einer dritten Drosselspule 119 umwickelt ist. Die erste Drosselspule 103 ist elektrisch mit einer ersten Wechselstromphase 133 des ersten Drehstromsystems 114 verbunden, die zweite Drosselspule 109 ist elektrisch mit einer zweiten Wechselstromphase 134 des ersten Drehstromsystems 114 und die dritte Drosselspule 119 ist elektrisch mit einer dritten Wechselstromphase 135 des ersten Drehstromsystems 114 verbunden.

Ein Wicklungsabstand 32 kennzeichnet jeweils den bzgl. der Einhaltung von Luft- und Kriechstrecken wichtigen räumlichen Abstand zwischen der ersten Drosselspule 103 und der zweiten Drosselspule 109, zwischen der zweiten Drosselspule 109 und der dritten Drosselspule 119 sowie der dritten Drosselspule 119 und der ersten Drosselspule 103.

Die FIG 6 zeigt eine erste schematische Darstellung der erfindungsgemäßen stromkompensierten Drosselvorrichtung 1 in einem Drehstromsystem.

Die erste Hauptdrosselspule 3 und die erste Hilfsdrosselspule 5 umwickeln jeweils den ersten Drosselkern 2, die zweite Hauptdrosselspule 9 und die zweite Hilfsdrosselspule 11 umwickeln jeweils den zweiten Drosselkern 8 und die dritte Hauptdrosselspule 19 und die dritte Hilfsdrosselspule 21 umwickeln jeweils den dritten Drosselkern 18.

Während die erste Hauptdrosselspule 3 mit der ersten Wechselspannungsphase 33 des erstes Drehstromsystem 14 elektrisch verbunden ist und im Betrieb ein Lastwechselstrom I_{w} in der ersten Wechselspannungsphase 33 fließt, ist die zweite Hauptdrosselspule 9 mit einer zweiten Wechselspannungsphase 34 des erstes Drehstromsystem 14 elektrisch verbunden, wobei im Betrieb der Lastwechselstrom I_{w} in der zweiten Wechselspannungsphase 34 fließt, und ist die dritte Hauptdrosselspule 19 mit einer dritten Wechselspannungsphase 35 des erstes Drehstromsystem 14 elektrisch verbunden, wobei im Betrieb der Lastwechselstrom I_{w} in der dritten Wechselspannungsphase 35 fließt.

Die erste Hilfsdrosselspule 5 der ersten Drosseleinheit 4 ist über deren ersten Anschluss 6 mit der zweiten Hilfsdrosselspule 11 der zweiten Drosseleinheit 10 mittels deren dritten Anschluss 12 und mit der dritten Hilfsdrosselspule 19 der dritten Drosseleinheit 20 mittels deren fünften Anschluss 22 verbunden. Ebenso ist die erste Hilfsdrosselspule 5 der ersten Drosseleinheit 4 ist über deren zweiten Anschluss 7 mit der zweiten Hilfsdrosselspule 11 der zweiten Drosseleinheit 10 mittels deren vierten Anschluss 13 und mit der dritten Hilfsdrosselspule 19 der dritten Drosseleinheit 20 mittels deren sechsten Anschluss 23 verbunden. Diese elektrischen Verbindungen bilden den Drosselstromkreis 17 aus.

In den Hauptdrosselspulen 3,9,19 fließt im Betrieb jeweils der Lastwechselstrom I_{W} und im Drosselstromkreis 17 der stromkompensierten Drosselvorrichtung 1, fließt der Kompensationsstrom I_{KOMP}, welcher die Gleichtaktstörungen kompensiert oder zumindest dämpft.

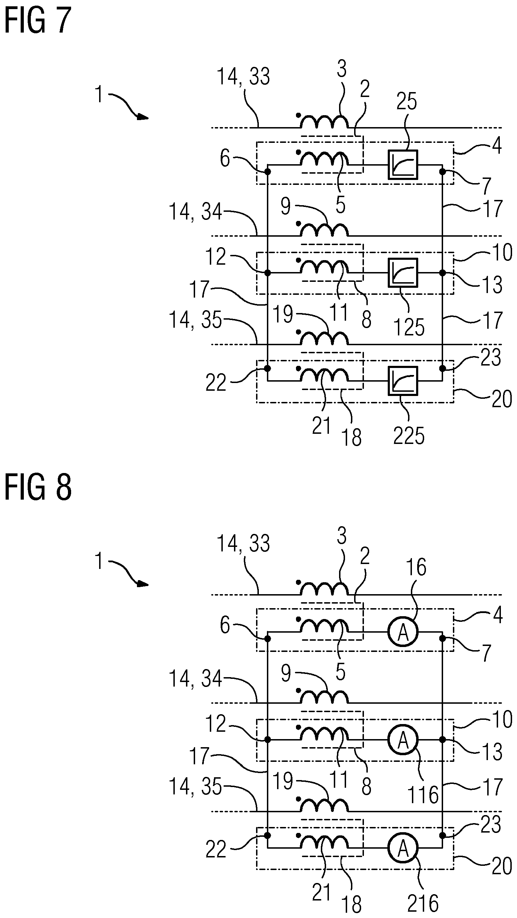

Die FIG 7 zeigt eine zweite schematische Darstellung der erfindungsgemäßen stromkompensierten Drosselvorrichtung 1 in dem Drehstromsystem nach FIG 6 auf, wobei in die erste Drosseleinheit 4 zusätzlich eine erste Filterkomponente 25 elektrisch mit der ersten Hilfsdrosselspule 5 und dem zweiten Anschluss 7 verbunden ist, wobei in die zweite Drosseleinheit 10 zusätzlich eine zweite Filterkomponente 125 elektrisch mit der zweiten Hilfsdrosselspule 11 und dem vierten Anschluss 13 verbunden ist und wobei in die dritte Drosseleinheit 20 zusätzlich eine erste Filterkomponente 225 elektrisch mit der dritten Hilfsdrosselspule 21 und dem sechsten Anschluss 23 verbunden ist.

Die FIG 8 zeigt eine dritte schematische Darstellung der erfindungsgemäßen stromkompensierten Drosselvorrichtung 1 in dem Drehstromsystem nach FIG 6 auf, wobei in die erste Drosseleinheit 4 zusätzlich eine erster Messsensor 16 elektrisch mit der ersten Hilfsdrosselspule 5 und dem zweiten Anschluss 7 verbunden ist, wobei in die zweite Drosseleinheit 10 zusätzlich eine zweiter Messsensor 116 elektrisch mit der zweiten Hilfsdrosselspule 11 und dem vierten Anschluss 13 verbunden ist und wobei in die dritte Drosseleinheit 20 zusätzlich eine dritter Messsensor 216 elektrisch mit der dritten Hilfsdrosselspule 21 und dem sechsten Anschluss 23 verbunden ist.

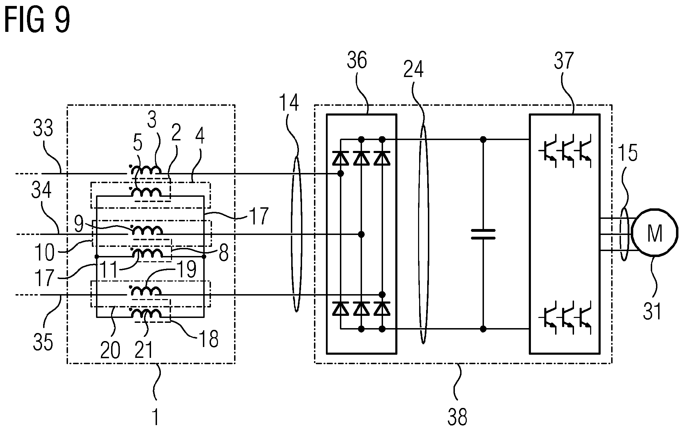

Mit FIG 9 wird eine schematische Darstellung eines Umrichters 38 mit der erfindungsgemäßen stromkompensierten Drosselvorrichtung 1 des Drehstromsystems nach FIG 6 offenbart.

Der Umrichter 38 ist über seinen Gleichrichter 36 mit einem ersten Drehstromsystem 14 elektrisch verbunden und über seinen Wechselrichter 37 mit einem zweiten Drehstromsystem 15 elektrisch verbunden. Eine mit dem zweiten Drehstromsystem 15 elektrisch verbundene elektrische Maschine 31 ist mittels des Umrichters 38 betreibbar.

Die stromkompensierte Drosselvorrichtung 1 ist hier im ersten Drehstromsystem 14 elektrisch angeordnet, wobei die stromkompensierte Drosselvorrichtung 1 der FIG 9 der stromkompensierte Drosselvorrichtung nach FIG 6 entspricht.

## Patentansprüche

1. Stromkompensierte Drosselvorrichtung (1) zur Filterung von Gleichtaktstörungen, umfassend
- einen ersten Drosselkern (2), aufweisend eine erste Hauptdrosselspule (3) und eine erste Drosseleinheit (4) mit einer ersten Hilfsdrosselspule (5),
- einen zweiten Drosselkern (6), aufweisend eine zweite Hauptdrosselspule (7) und eine zweite Drosseleinheit (8) mit einer zweiten Hilfsdrosselspule (9), und
- einen Drosselstromkreis (17), wobei:
- die erste Hauptdrosselspule (3) und die erste Hilfsdrosselspule (5) jeweils den ersten Drosselkern (2) umwickeln,
- die zweite Hauptdrosselspule (7) und die zweite Hilfsdrosselspule (9) jeweils den zweiten Drosselkern (6) umwickeln,
- die erste Hilfsdrosselspule (5) zwischen einem ersten Anschluss (10) und einem zweiten Anschluss (11) der ersten Drosseleinheit (4) und die zweite Hilfsdrosselspule (11) zwischen einem dritten und einem vierten Anschluss (12,13) der zweiten Drosseleinheit (10) elektrisch verbunden ist und
- der erste Anschluss (6) mit dem dritten Anschluss (12) und der zweite Anschluss (7) mit dem vierten Anschluss (13) elektrisch verbunden ist und die Verbindungen dieser Anschlüsse den Drosselstromkreis (17) ausbildet.

2. Stromkompensierte Drosselvorrichtung (1) nach Anspruch 1, umfassend einen dritten Drosselkern (18), eine dritte Hauptdrosselspule (19) und eine dritte Drosseleinheit (20), welche eine dritte Hilfsdrosselspule (21) aufweist, wobei:
- die dritte Hauptdrosselspule (19) und die dritte Hilfsdrosselspule (21) jeweils den dritten Drosselkern (18) umwickeln,
- die dritte Hilfsdrosselspule (21) zwischen einem fünften und einem sechsten Anschluss (22,23) der dritten Drosseleinheit (20) elektrisch verbunden ist und
- der fünfte Anschluss (22) jeweils mit dem ersten Anschluss (6) und dem dritten Anschluss (12) und der sechste Anschluss (23) jeweils mit dem zweiten Anschluss (7) und dem vierten Anschluss (13) am Drosselstromkreis (17) elektrisch verbunden ist.

3. Stromkompensierte Drosselvorrichtung (1) nach einem der Ansprüche 1 oder 2, wobei
- die erste Hauptdrosselspule (3) separat und überlappungsfrei von der ersten Hilfsdrosselspule (5) den ersten Drosselkern (2) umwickelt,
- die zweite Hauptdrosselspule (7) separat und überlappungsfrei von der zweiten Hilfsdrosselspule (9) den zweiten Drosselkern (6) umwickelt und
- die dritte Hauptdrosselspule (19) separat und überlappungsfrei von der dritten Hilfsdrosselspule (21) den, soweit vorhanden, dritten Drosselkern (18) umwickelt.

4. Stromkompensierte Drosselvorrichtung (1) nach einem der vorhergehenden Ansprüche, wobei der erste und der zweite Drosselkern (2,8) und, soweit vorhanden, der dritte Drosselkern (18) kreisförmig ausgebildet sind, insbesondere in Form einer Ringkerndrossel, oder rechteckförmig ausgebildet sind.

5. Stromkompensierte Drosselvorrichtung (1) nach einem der vorhergehenden Ansprüche, wobei
- die erste Drosseleinheit (4) einen ersten Messsensor (16) aufweist, welcher gemeinsam mit der ersten Hilfsdrosselspule (5) elektrisch zwischen dem ersten Anschluss (10) und dem zweiten Anschluss (11) der ersten Drosseleinheit (4) verbunden ist und/oder
- die zweite Drosseleinheit (10) einen zweiten Messsensor (116) aufweist, welcher gemeinsam mit der zweiten Hilfsdrosselspule (5) elektrisch zwischen dem dritten Anschluss (12) und dem vierten Anschluss (13) der zweiten Drosseleinheit (10) verbunden ist und/oder
- die, soweit vorhanden, dritte Drosseleinheit (20) einen dritten Messsensor (216) aufweist, welcher gemeinsam mit der dritten Hilfsdrosselspule (21) elektrisch zwischen dem fünften Anschluss (22) und dem sechsten Anschluss (13) der dritten Drosseleinheit (20) verbunden ist.

6. Stromkompensierte Drosselvorrichtung (1) nach einem der vorhergehenden Ansprüche, wobei
- die erste Drosseleinheit (4) eine erste Filterkomponente (25) aufweist, welche gemeinsam mit der ersten Hilfsdrosselspule (5) elektrisch zwischen dem ersten Anschluss (10) und dem zweiten Anschluss (11) der ersten Drosseleinheit (4) verbunden ist und/oder
- die zweite Drosseleinheit (10) eine zweite Filterkomponente (125) aufweist, welche gemeinsam mit der zweiten Hilfsdrosselspule (5) elektrisch zwischen dem dritten Anschluss (12) und dem vierten Anschluss (13) der zweiten Drosseleinheit (10) verbunden ist und/oder
- die, soweit vorhanden, dritte Drosseleinheit (20) eine dritte Filterkomponente (225) aufweist, welche gemeinsam mit der dritten Hilfsdrosselspule (21) elektrisch zwischen dem fünften Anschluss (22) und dem sechsten Anschluss (13) der dritten Drosseleinheit (20) verbunden ist.

7. Stromkompensierte Drosselvorrichtung (1) nach einem der vorhergehenden Ansprüche, wobei der erste und der zweite Drosselkern (2,8) und, soweit vorhanden, der dritte Drosselkern (18) jeweils Ferritkerne oder jeweils Pulverkerne sind.

8. Umrichter (38) zum Betreiben einer elektrischen Maschine (31), aufweisend
- eine stromkompensierte Drosselvorrichtung (1) nach einem der vorhergehenden Ansprüche,
- einen Gleichrichter (36), der elektrisch mit einem ersten Drehstromsystem (14) verbunden ist,
- einen Wechselrichter (37), der elektrisch mit einem zweiten Drehstromsystem (15) verbunden ist und
- einen Gleichspannungszwischenkreis (24), der den Gleichrichter (36) mit dem Wechselrichter (37) elektrisch verbindet.

9. Umrichter (38) nach Anspruch 8, wobei die stromkompensierte Drosselvorrichtung (1) in dem ersten Drehstromsystem (14) elektrisch angeordnet ist.

10. Umrichter (38) nach Anspruch 8, wobei die stromkompensierte Drosselvorrichtung (1) in dem zweiten Drehstromsystem (14) elektrisch angeordnet ist.

11. Umrichter (38) nach Anspruch 8, wobei die stromkompensierte Drosselvorrichtung (1) in dem Gleichspannungszwischenkreis (24) elektrisch angeordnet ist.

12. Umrichter (38) nach einem der Ansprüche 8 bis 11, wobei die stromkompensierte Drosselvorrichtung (1) in den Umrichter (38) integriert ist.
